# EUROPÄISCHE PATENTSCHRIFT

(11) **EP 4 533 110 B1**
(45) Veröffentlichungstag und Bekanntmachung des Hinweises auf die Patenterteilung: **29.07.2026**
(21) Anmeldenummer: 23727876.7
(22) Anmeldetag: 26.05.2023
(51) Int. Cl.: G01R 31/36, H01M 10/42, H01M 10/44, H01M 10/48

(54) **VORRICHTUNG UND VERFAHREN ZUM PRÜFEN EINER ZELLKONTAKTIERUNG VON BATTERIEZELLEN EINES BATTERIEMODULS**
APPARATUS AND METHOD FOR TESTING A CELL CONTACT OF BATTERY CELLS OF A BATTERY MODULE
APPAREIL ET PROCÉDÉ PERMETTANT DE TESTER UN CONTACT CELLULAIRE D'ÉLÉMENTS DE BATTERIE D'UN MODULE DE BATTERIE

(30) Priorität: 27.05.2022 DE 102022113467
(43) Veröffentlichungstag der Anmeldung: 09.04.2025
(73) Patentinhaber: Acculogic GmbH, 22453 Hamburg (DE); Acculogic Inc., Markham, ON L3R 5J6 (CA)
(72) Erfinder: DEHKORDI, Karim, Trabuco Canyon, California 92679 (US); PARASCHIV, Bogdan, Toronto, Ontario ON M2K 2J9 (CA)
(74) Vertreter: Eisenführ Speiser
(86) Internationale Anmeldenummer: PCT/EP2023/064148
(87) Internationale Veröffentlichungsnummer: WO 2023/227759

(56) Entgegenhaltungen:
- WO-A1-2021/044155
- WO-A1-2021/044169
- CN-A- 113 296 012
- JP-A- 2012 169 244
- JP-A- 2023 055 143
- US-A1- 2017 269 142
- US-A1- 2020 083 513

## Beschreibung

Die vorliegende Erfindung betrifft eine Vorrichtung zum Prüfen einer Zellkontaktierung von Batteriezellen eines Batteriemoduls. Zudem betrifft die vorliegende Erfindung ein Verfahren zum Prüfen einer Zellkontaktierung von Batteriezellen eines Batteriemoduls.

Batteriemodule sind grundsätzlich bekannt. Batteriemodule werden beispielsweise für Elektrofahrzeuge unter Verwendung handelsüblicher Lithium-Ionen-Batterien eingesetzt. Batteriemodule sind aus einer Vielzahl von Batterien ausgebildet, die nachfolgend als Batteriezellen bezeichnet werden. Die Batteriezellen werden beispielsweise im AA-Format hergestellt und anschließend parallelgeschaltet (Parallelschaltung), um ein Batteriemodul aus z.B. 500 einzelnen Batteriezellen auszubilden. Um eine erforderliche Betriebsspannung zu erreichen, ist es zudem bekannt, die Batteriezellen in Serie zu schalten (Reihenschaltung).

Größere Batteriemodule wie sie beispielsweise in Elektrofahrzeugen oder in temporären Energiespeichern eingesetzt werden, weisen also eine sehr große Anzahl von parallel und/oder in Serie geschalteten Batteriezellen auf. Dies führt zu Problemen bei den nach der Herstellung des Batteriemoduls erforderlichen Tests.

Es ist auch bekannt, dass die Batteriezellen eines Batteriemoduls über Stromschienen parallel verbunden werden. Um die Batteriezellen mit der Stromschiene zu verbinden, sind verschiedene Verbindungstechniken bekannt. Beispielsweise ist es bekannt, die Batteriezellen an ihren Kontaktstellen zu verlöten oder zu verschweißen, wobei im Bereich des Schweißens zum Beispiel Laser- oder Ultraschallschweißen bekannte Verfahren sind, um die Batteriezellen elektrisch zu kontaktieren, beispielsweise mit den Stromschienen. Es ist ebenfalls bekannt, Klemm- oder Steckverbindungen als Verbindungsmittel einzusetzen, um die Batteriezellen zu kontaktieren. Die Verbindungen zwischen den Batteriezellen und der entsprechenden Stromschiene können also auf vielfältige Weise hergestellt werden. Die Kontaktstellen sind auch als Anschlussstellen, Anschlusspole oder Pole bekannt.

Die Verbindung von Stromschiene und den Batteriezellen erfolgt dabei nicht zwingend direkt, sondern es können auch Verbindungsleiter, z.B. in Form von Verbindungsdrähten oder -kabeln, vorgesehen sein, um die Batteriezellen über die Verbindungsleiter mit der Stromschiene elektrisch zu verbinden. Um eine Batteriezelle mit einer Stromschiene zu verbinden, sind bei Verwendung eines Verbindungsleiters entsprechend vier elektrische Verbindungen herzustellen. Ein erster Verbindungsleiter ist nämlich an einer ersten Seite mit dem Anodenkontakt (Pluspol) der Batteriezelle elektrisch zu verbinden und an einer zweiten Seite ist er mit der Stromschiene für den Pluspol der Batteriezellen elektrisch zu verbinden. Das gleiche Prinzip wird analog für einen zweiten Verbindungsleiter durchgeführt, um den Kathodenkontakt (Minuspol) und die Stromschiene für den Minuspol der Batteriezellen elektrisch zu verbinden.

Es kann dabei vorkommen, dass die elektrische Verbindung zwischen den Batteriezellen und den Stromschienen nicht elektrisch leitend oder nur schlecht elektrisch leitend ist, z.B. weil die Schweiß-, Klemm- oder Steckverbindung ungenügend ausgeführt ist. Dies ist ungewünscht und kann aufgrund von Herstellungs- und Toleranzschwankungen vorkommen. Es werden deshalb Anstrengungen unternommen, um die elektrischen Kontaktstellen der Batteriezellen zu prüfen. Aufgrund der Vielzahl von zu prüfenden Kontaktstellen, die als Prüfstellen bezeichnet werden, sind Vorrichtungen zum automatisierten Prüfen der Zellkontaktierungen der Batteriezellen des Batteriemoduls bekannt. Beispielsweise ist eine solche Vorrichtung aus dem Dokument EP 3 114 491 B1 bekannt. In dem Dokument EP 3 114 491 B1 ist eine Vorrichtung beschrieben, die mit einer Widerstandsmessung arbeitet. Das Grundprinzip der dort beschriebenen Vorrichtung ist, dass die elektrische Leitfähigkeit der Prüfstellen geprüft wird, indem paarweise zwei Kontaktelektroden an eine Vielzahl von Prüfstellen mit einem automatisierten Positioniersystem positioniert werden, und eine Widerstandmessung zwischen den beiden Kontaktelektroden erfolgt, um die Leitfähigkeit der Prüfstelle festzustellen. Liegt ein zu hoher Widerstandswert vor, wird von einer schlechten Prüfstelle bzw. von einer schlechten elektrischen Kontaktierung ausgegangen. Problematisch an der Widerstandsmessung ist dabei, dass mit der Widerstandsmessung jede Kontaktstelle einzeln geprüft werden muss. Dies ist problematisch, da der Prüfprozess aller einzelnen Kontaktstellen insgesamt zeitaufwendig ist. Zudem ist problematisch, dass die Kontaktelektroden für die Widerstandsmessung unmittelbar mit den Prüfstellen in elektrischen Kontakt gebracht werden müssen, was eine genaue Positionierung der Kontaktelektroden erforderlich macht. Die genaue Positionierung stellt eine besonders große Herausforderung dar, weil die Kontakte der Batteriezellen aufgrund von Fertigungsschwankungen und Prozessschwankungen bei der Batteriemodulherstellung nicht immer an der gleichen Position angeordnet sind und damit die Prüfstellen trotz baugleicher Batteriemodule an unterschiedlichen Stellen sein können. Dem wird mit Einmessverfahren oder der Einhaltung von kleinen Fertigungstoleranzen entgegengewirkt, was aufwendig ist. Zudem müssen die Kontaktelektroden eine gewisse Kraft auf die Prüfstellen ausüben, damit sichergestellt wird, dass die Elektroden richtig auf den Prüfstellen aufliegen. Es versteht sich, dass sich deshalb auch die Kontaktelektroden abnutzen können und bei einer Verschmutzung ggf. falsche Prüfergebnisse vorliegen.

In der prioritätsbegründenden deutschen Patentanmeldung hat das Deutsche Patent- und Markenamt die folgenden Dokumente recherchiert: DE 31 41 315 A1, DE 11 2014 000 982 T5 und EP 2 703 830 A2. Dokument CN 113296012 A offenbart ein Verfahren und eine Vorrichtung zur Fehlererkennung von Lithium-Batteriepacks mittels In-situ-Magnetfeldabbildung.

Aufgabe der vorliegenden Erfindung ist es deshalb, eines der oben genannten Probleme zu adressieren, den allgemeinen Stand der Technik zu verbessern oder eine Alternative zu bisher Bekanntem bereitzustellen. Insbesondere soll eine Lösung bereitgestellt werden, mit der der Prüfprozess der Zellkontaktierung von Batteriezellen beschleunigt werden kann. Insbesondere soll auch ein einfacheres und robusteres Prüfsystem zum Prüfen der Zellkontaktierung von Batteriezellen bereitgestellt werden.

Zur Lösung wird eine Vorrichtung zum Prüfen einer Zellkontaktierung von Batteriezellen eines Batteriemoduls nach Anspruch 1 vorgeschlagen.

Es wird also eine Prüfvorrichtung vorgeschlagen, die zum Prüfen einer Zellkontaktierung von Batteriezellen vorgesehen und eingerichtet ist. Das Prüfen der Zellkontaktierung kann auch als Prüfen der Kontaktstellen oder Verbindungsstellen der Batteriezellen aufgefasst werden, an denen die Batteriezellen elektrisch kontaktiert ist. Die Batteriezelle kann synonym auch als Batterie oder als Akkumulator (aufladbare Batterie) verstanden werden. Die Batteriezelle ist Teil eines Batteriemoduls. Das Batteriemodul ist aus einer Vielzahl von Batteriezellen ausgebildet, die miteinander elektrisch kontaktiert bzw. verbunden sind, beispielsweise sind die Batteriezellen des Batteriemoduls parallel oder seriell, d.h. in Serie, geschaltet. Mit der Prüfvorrichtung soll also die ordnungsgemäße elektrische Verbindung eines Batteriemoduls geprüft werden, also ob die elektrische Verbindung der Batteriezellen ordnungsgemäß bei der Herstellung des Batteriemoduls hergestellt wurden. Erfolgt die Zellkontaktierung der Batteriezellen, also das Herstellen einer elektrisch leitenden Verbindung, beispielsweise mit einem Laserschweißverfahren, werden also mit der Prüfvorrichtung die lasergeschweißten Verbindungsstellen bzw. Punkte des Batteriemoduls geprüft.

Es wird vorgeschlagen, dass mehrere Batteriezellen des Batteriemoduls elektrisch parallel über ein Kontaktierungssystem miteinander verbunden sind. Elektrisch parallel geschaltet bedeutet dabei, dass mehrere Minuspole der Batteriezellen elektrisch miteinander verbunden sind, genauso wie mehrere Pluspole der Batteriezellen elektrisch miteinander verbunden sind. Um die Batteriezellen miteinander zu verbinden, ist ein Kontaktierungssystem vorgesehen. Das Kontaktierungssystem ist ein System zum elektrischen Kontaktieren der Batteriezellen miteinander. An das Kontaktierungssystem können zudem weitere Komponenten des Batteriemoduls angeschlossen werden, wie ein Batteriemanagementsystem oder Schutzschaltungen, beispielsweise zum Tiefenentladeschutz oder Kurzschlussschutz. Das Kontaktierungssystem bezieht sich also auf die elektrische Verbindungstechnik. Beispielsweise ist das Kontaktierungssystem aus mehreren parallel geschalteten Stromschienen sowie mehreren Verbindungsleitern ausgebildet, die die Stromschienen und die Batteriezellen elektrisch leitfähig verbinden.

Die Prüfvorrichtung umfasst ein Sensorpositioniersystem zum Positionieren einer Sensoreinrichtung an einer Vielzahl von Prüfstellen des Batteriemoduls, wobei das Sensorpositioniersystem zum Positionieren der Sensoreinrichtung verfahrbar entlang einer Längsasche, einer Querachse und einer Hochachse ausgebildet ist. Diese Achsen spannen einen dreidimensionalen Raum auf, sodass die Sensoreinrichtung an einen beliebigen Punkt im Raum verfahren werden kann. Das Sensorpositioniersystem ist ein automatisiertes System, mit dem eine Sensoreinrichtung an der jeweiligen Prüfstelle angeordnet bzw. platziert wird. Das Sensorpositioniersystem ist beispielsweise ausgebildet, wie im Stand der Technik in der EP 3 114 491 B1 beschrieben, mit mehreren unabhängig verfahrbaren Sensorhalterungen. Mit dem Sensorpositioniersystem können gleichzeitig mehrere Prüfstellen angefahren werden oder auch mehrere Prüfstellen zeitlich hintereinander angefahren werden. Das Sensorpositioniersystem positioniert also die Sensoreinrichtung an allen zu prüfenden Kontaktstellen des Batteriemoduls, damit mit der Sensoreinrichtung alle Prüfstellen geprüft werden können. Der Positioniervorgang erfolgt dabei automatisiert. Um alle Prüfstellen zu erreichen, ist das Sensorpositioniersystem verfahrbar ausgebildet und kann die Sensoreinrichtung entlang der Querachse, der Hochachse und der Längsachse bewegen. Verfahrbar kann dabei auch als bewegbar oder positionierbar aufgefasst werden. Die Sensoreinrichtung kann also beliebig im dreidimensionalen Raum mit dem Sensorpositioniersystem bewegt werden. Das Bewegen oder Verfahren entlang der Längsachse kann dabei als eine Vorwärts- oder Rückwärtsbewegung verstanden werden. Das Bewegen entlang der Querachse kann dabei als eine Links- oder Rechtsbewegung verstanden werden. Das Bewegen entlang der Hochachse kann dabei als eine Aufwärts- und Abwärtsbewegung verstanden werden. Der Aufbau des Sensorpositioniersystems ist grundsätzlich beliebig, es kann beispielsweise wie in der EP 3 114 491 B1 beschrieben mit mehreren verfahrbaren Sensorhalterungen ausgebildet sein, es kann aber auch beispielsweise mit einem Industrieroboter oder einem dreiachsig verfahrbaren Sensorkopf, wie bei einem 3D-Drucker, ausgebildet sein.

Es wird jede Prüfstelle des Batteriemoduls automatisiert mit dem Positioniersystem angefahren und die Sensoreinrichtung wird an allen Prüfstellen des Batteriemoduls zum Durchführen einer Messung angeordnet. Das Positionieren der Sensoreinrichtung mit dem Sensorpositioniersystem kann dabei nach einem festgelegten Ablaufplan erfolgen, der beispielsweise in einer Steuereinrichtung der Prüfvorrichtung oder in dem Sensorpositioniersystem hinterlegt ist. Sobald die Prüfung an einer Prüfstelle abgeschlossen ist, positioniert das Sensorpositioniersystem die Sensoreinrichtung an einer oder mehreren neuen Prüfstellen.

Die Prüfvorrichtung umfasst vorzugsweise eine Steuereinrichtung zum Steuern des Sensorpositioniersystems und zum Ansteuern der Stromerzeugungsschaltung und ist bevorzugt datentechnisch mit einer Auswertungseinrichtung und/oder der Sensoreinrichtung verbunden. Die Steuereinrichtung ist dazu vorgesehen und eingerichtet, das Prüfverfahren zu koordinieren, also das Anfahren der Prüfstellen mit dem Positioniersystem, das Erzeugen des Batteriestroms mit der Stromerzeugungsschaltung, den Messvorgang mit der Sensoreinrichtung und den Auswertungsvorgang mit der Auswertungseinrichtung steuerungstechnisch zu koordinieren.

Die Prüfvorrichtung umfasst zudem eine Stromerzeugungsschaltung zum Erzeugen eines Batteriezellenstroms, wobei der Batteriezellenstrom ein Entladestrom aus der Batteriezelle ist oder ein Ladestrom in die Batteriezelle hinein. Es wird also vorgeschlagen, dass mit einer technischen Einrichtung ein Strom erzeugt wird, der aus der Batteriezelle entnommen wird oder der in die Batteriezelle eingespeist wird. Der Batteriezellenstrom ist also ein elektrischer Strom, der von der Batteriezelle erzeugt wird. Die Batteriezelle arbeitet also als Stromquelle. Der Batteriezellenstrom kann auch ein elektrischer Strom sein, der von einer anderen Stromquelle erzeugt wird und dann in die Batteriezelle eingespeist wird. Es versteht sich, dass der Batteriezellenstrom ein Gleichstrom ist. Es versteht sich zudem, dass die Stromerzeugungsschaltung so mit der Batteriezelle oder den mehreren Batteriezellen verbunden ist, dass sich der Entladestrom oder der Ladestrom einstellt. Die Stromerzeugungsschaltung ist an das Kontaktierungssystem elektrisch angeschlossen, damit sich die zu prüfende Batteriezelle über das Kontaktierungssystem und die Stromerzeugungsschaltung entladen kann oder damit die zu prüfende Batteriezelle über das Kontaktierungssystem und die Stromerzeugungsschaltung geladen werden kann. Es versteht sich, dass im Fall des Entladestroms die Batteriezelle vorgeladen ist. Zum Entladen oder Laden wird also ein geschlossener Stromkreis zwischen dem Pluspol und dem Minuspol der zu prüfenden Batteriezelle mittels der Stromerzeugungsschaltung hergestellt, damit sich der Batteriezellenstrom aus der zu prüfenden Batteriezelle heraus oder in sie hinein einstellt.

Die Prüfvorrichtung umfasst zudem eine Sensoreinrichtung, die mit wenigstens einem Feldsensor ausgebildet ist. Der Feldsensor ist nach Positionierung der Sensoreinrichtung an einer der Prüfstellen dazu eingerichtet, ein Feld im Bereich der Prüfstelle zu erfassen, das durch den mit der Stromerzeugungsschaltung erzeugten Batteriezellenstrom erzeugt wird. Ein solches Feld entsteht nämlich, wenn im Bereich der Prüfstelle ein Strom fließt. Der Feldsensor kann auch als Sensorkopf aufgefasst werden. Es ist bekannt, dass ein elektrisches Feld von ruhenden sowie bewegten Ladungen erzeugt wird und ein Magnetfeld von bewegten Ladungen. Bewegte Ladungen sind synonym auch als elektrischer Strom bekannt. Das Feld bezieht sich demnach auf ein Magnetfeld und/oder auf ein elektrisches Feld, da es von dem Batteriezellenstrom erzeugt wird, d.h. von bewegten Ladungen erzeugt wird. Der Feldsensor ist also ein Sensor, der dazu eingerichtet ist, ein Magnetfeld und/oder elektrisches Feld zu detektieren. Nach Positionierung der Sensoreinrichtung im Bereich der Prüfstelle, erfasst der Feldsensor ein Magnetfeld und/oder ein elektrisches Feld, das durch den Batteriezellenstrom erzeugt wird, wobei der Batteriezellenstrom mit der Stromerzeugungsschaltung erzeugt wird. Das Magnetfeld ist dabei durch eine magnetische Flussdichte (B) und eine magnetische Feldstärke (H) charakterisiert. Das elektrische Feld ist durch eine elektrische Flussdichte (D) und eine elektrische Feldstärke (E) charakterisiert. Der Feldsensor kann also beispielsweise ein Magnetometer und/oder ein Elektrofeldmeter sein. Bekannte Magnetometer sind zum Beispielspiel Hallsensoren, Spulen, Förster-Sonden, SQUIDs (supraleitendes Quanteninterferenzgerät), Protonenmagnetometer oder dergleichen.

Eine Prüfstelle ist eine Stelle im Bereich der zu prüfenden Batteriezelle, an der das durch den Batteriezellenstrom erzeugte Feld messbar ist. Geeignete Prüfstellen sind beispielsweise Stellen in unmittelbarer Nähe der Kontaktstellen der Batteriezellen, also im Bereich der Anoden- und/oder der Kathodenanschlüsse der Batteriezellen. Eine weitere geeignete Prüfstelle ist im Bereich der Verbindungsleiter, die die Stromschiene und die Batteriezellen elektrisch verbinden. Zudem ist eine weitere geeignete Prüfstelle eine Stelle in dem Bereich, wo ein Verbindungsleiter der Batteriezelle mit der Stromschiene verbunden ist.

Der Feldsensor ist also zum kontaktlosen Erfassen eines Magnetfeldes und/oder elektrischen Feldes im Bereich der Prüfstelle ausgebildet.

Es wurde vorliegend erkannt, dass anstatt einer Widerstandsmessung wie aus dem Stand der Technik bekannt, z.B. aus der EP 3 114 491 B1, eine Messung eines Magnetfeldes und/oder elektrischen Feldes im Bereich der Prüfstelle besonders vorteilhaft ist, da nicht jede Kontaktstelle an jeder Batteriezelle einzeln geprüft werden muss. Es wird dabei der Effekt ausgenutzt, dass sich kein geschlossener Stromkreis zwischen dem Pluspol und dem Minuspol der zu prüfenden Batteriezelle einstellt, wenn einer der beiden Kontaktstellen an der zu prüfenden Batteriezelle keinen oder einen schlechten elektrischen Kontakt aufweist. Ist der Pluspol oder der Minuspol nicht richtig kontaktiert, stellt sich kein oder nur ein geringer Batteriezellenstrom an der Batteriezelle ein und es wird entsprechend auch kein messbares oder ein nur gering messbares Feld induziert. So kann mit einer einzigen Messung festgestellt werden, ob der Pluspol und der Minuspol der Batteriezellen korrekt mit dem Kontaktierungssystem kontaktiert sind. Dies bedeutet auch, dass ,wenn zum Beispiel Stromschienen mit Verbindungsleitern als Kontaktierungssystem eingesetzt werden, mit einer einzigen Messung vier Kontaktstellen der Batteriezellen gleichzeitig geprüft werden können, nämlich die Verbindung zwischen Pluspol mit einem ersten Verbindungsleiter, die Verbindung zwischen dem ersten Verbindungsleiter und der positiven Stromschiene, an der die Pluspole der Batteriezellen angeschlossen sind, die Verbindung zwischen dem Minuspol mit einem zweiten Verbindungsleiter und die Verbindung zwischen dem zweiten Verbindungsleiter und der negativen Stromschiene, an der die Minuspole der Batteriezellen angeschlossen sind. Mit einem Widerstandsmessverfahren müssten alle vier Prüfstellen an der Batteriezelle einzeln geprüft werden. Mit der erfindungsgemäßen Vorrichtung und Vorgehensweise wird die Zeitdauer des Prüfverfahrens reduziert. Zudem wird das mit dem Batteriezellenstrom erzeugte Feld kontaktlos gemessen, womit das System weniger anfällig für Verschmutzungen ist. Außerdem erstreckt sich das mittels des Batteriezellenstroms erzeugte Magnetfeld und/oder das elektrische Feld über einen räumlich größeren Bereich, womit der Feldsensor nicht so genau positioniert werden muss, wie bei einer Widerstandsmessung, bei der die Kontaktstellen getroffen werden müssen.

Vorzugsweise ist die Sensoreinrichtung mit dem Feldsensor dazu eingerichtet, eine magnetische Flussdichte und/oder eine magnetische Feldstärke zu erfassen, und die Vorrichtung ist mit einer Auswertungseinrichtung dazu eingerichtet, die erfasste magnetische Flussdichte und/oder die erfasste magnetische Feldstärke auszuwerten. Es wird demnach vorgeschlagen, einen Magnetfeldsensor zum Detektieren eines Magnetfeldes zu verwenden, das durch den Batteriezellenstrom erzeugt wird. Vorteilhaft daran ist, dass die magnetische Flussdichte und die magnetische Feldstärke von der Stromstärke des Batteriezellenstroms abhängig sind und somit unterschiedlich starke Magnetfelder bei unterschiedlichen Batteriezellenströmen erzeugt werden. Durch die Auswertung der magnetischen Größen können Rückschlüsse auf die Kontaktqualität vorgenommen werden, denn wenn beispielsweise ein schlechter elektrischer Kontakt vorliegt, ist der Widerstand höher und ein geringerer Strom fließt, im Vergleich zu einem gut leitfähigen Kontakt. Entsprechend ist das Magnetfeld bei einem schlechten elektrischen Kontakt niedriger als bei einem gut leitfähigen Kontakt. Es versteht sich, dass die Sensoreinrichtung und die Auswertungseinrichtung dazu datentechnisch miteinander gekoppelt sind.

Vorzugsweise ist die Sensoreinrichtung mit dem Feldsensor dazu eingerichtet, eine elektrische Flussdichte und/oder eine elektrische Feldstärke zu erfassen, und die Vorrichtung ist mit einer Auswertungseinrichtung dazu eingerichtet, die erfasste elektrische Flussdichte und/oder die erfasste elektrische Feldstärke auszuwerten. Es wird demnach vorgeschlagen, einen Feldsensor zum Detektieren eines elektrischen Feldes zu verwenden, das im Bereich der Prüfstelle erzeugt wird. Vorteilhaft daran ist, dass die elektrische Flussdichte und die elektrische Feldstärke einen Rückschluss auf das anliegende elektrische Potential an der Prüfstelle zulassen. Durch die Auswertung des elektrischen Feldes können also Rückschlüsse auf die Kontaktqualität und auf das an den Batteriekontakten anliegende elektrische Potential vorgenommen werden. Es versteht sich, dass die Sensoreinrichtung und die Auswertungseinrichtung dazu datentechnisch miteinander gekoppelt sind.

Vorzugsweise sind die Batteriezellen elektrisch vorgeladen und die Stromerzeugungsschaltung ist als Entladungsschaltung mit einem Lastwiderstand zum Entladen der vorgeladenen Batteriezellen über das Kontaktierungssystem ausgebildet, um den Batteriezellenstrom als Entladestrom zwischen Kontaktstellen der Batteriezellen zu erzeugen. In diesem Fall arbeitet die Batteriezelle bzw. arbeiten die Batteriezellen als Stromquelle zum Erzeugen des Batteriezellenstroms. Die Stromerzeugungsschaltung stellt einen geschlossenen Stromkreis zwischen dem Pluspol und dem Minuspol der Batteriezellen her, so dass sich die Batteriezellen über das Kontaktierungssystem und den Lastwiderstand entladen. Der Lastwiderstand ist beispielsweise steuerbar ausgebildet und über einen steuerbaren Schalter können die Kontaktstellen der Batteriezellen elektrisch leitend über den Lastwiderstand verbunden werden. Als Kontaktstellen werden dabei die Anschlussstellen zum Kontaktieren der Batteriezelle verstanden, also zum Beispiel die Anschlussstellen für den Pluspol und den Minuspol. Das Vorladen der Batteriezellen kann außerhalb der Prüfvorrichtung und vor dem Prüfverfahren erfolgen. Optional kann dieses Vorladen auch als Teil des Prüfungsverfahrens vorgesehen werden, wobei dieses Vorladen auch unmittelbar nach Herstellung der Batteriezellen erfolgen kann und mit zeitlichem Abstand zu den weiteren Schritten des Prüfungsverfahrens. Ein elektrisch vorgeladener Zustand liegt dabei vor, wenn die Batteriezelle zumindest teilweise elektrisch geladen ist und der Batteriezelle der Batteriezellenstrom als Entladestrom entnommen werden kann.

Vorzugsweise sind die Batteriezellen elektrisch aufladbar und die Stromerzeugungsschaltung ist als Ladeschaltung zum Laden der Batteriezellen über das Kontaktierungssystem ausgebildet, um den Batteriezellenstrom als einen Ladestrom zwischen Kontaktstellen der Batteriezellen zu erzeugen. In diesem Fall arbeitet die Batteriezelle bzw. arbeiten die Batteriezellen als elektrischer Speicher in den der erzeugte Batteriezellenstrom eingespeist wird. Die Stromerzeugungsschaltung stellt einen geschlossenen Stromkreis zwischen dem Pluspol und dem Minuspol der Batteriezellen her, so dass die Batteriezellen über das Kontaktierungssystem aufgeladen werden können. Zudem umfasst die Stromerzeugungsschaltung eine Stromquelle bzw. Energiequelle, um den Batteriezellenstrom zu erzeugen, der in die als Energiespeicher arbeitenden Batteriezellen eingespeist wird. Das Aufladen der Batteriezellen kann während der Prüfung mit der Prüfvorrichtung erfolgen. Die Stromquelle bzw. Energiequelle zum Aufladen der Batteriezellen kann beispielsweise eine gleichgerichtete Netzspannung aus einem elektrischen Versorgungsnetz sein. Die Ladeschaltung kann auch als Batterieladegerät verstanden werden. Batterieladegeräte sind grundsätzlich bekannt.

Vorzugsweise weist der Feldsensor wenigstens zwei Sensoren auf, wobei einer der Sensoren zum Erfassen eines im Bereich einer Anodenkontaktstelle der Batteriezelle erzeugten Feldes ausgebildet ist und ein anderer Sensoren ist zum Erfassen eines im Bereich einer Kathodenkontaktstelle erzeugten Feldes ausgebildet, insbesondere um gleichzeitig das Feld an der Anodenkontaktstelle und an der Kathodenkontaktstelle der Batteriezelle zu prüfen. Es wird also vorgeschlagen, wenigstens zwei Sensoren an einem Sensorkopf anzuordnen, mit denen gleichzeitig die Kontaktstelle an der Anode und an der Kathode der Batteriezelle geprüft werden. Die Kathodenkontaktstelle bezieht sich auf den Minuspol bzw. den Kathodenanschluss der Batteriezelle. Die Anodenkontaktstelle bezieht sich auf den Pluspol bzw. den Anodenanschluss der Batteriezelle. In einer besonderen Ausführungsform sind die zwei Sensoren paarweise gegenüberliegend und beabstandet zueinander angeordnet. Werden zwei Sensoren für den Feldsensor vorgesehen, wird vorteilhafterweise erreicht, dass das detektierte Feld im Bereich der Anodenkontaktstelle mit dem detektierten Feld im Bereich der Kathodenkontaktstelle verglichen werden kann. Zudem können die beiden erfassten Signale gemittelt werden, um Messungenauigkeiten auszugleichen und durch die Verwendung von zwei Sensoren vergrößert sich der Messbereich, womit der Sensor nicht so genau positioniert werden muss. Der Abstand der Sensoren ist dabei bevorzugt so gewählt, dass er dem Abstand zwischen Anodenkontaktstelle und Kathodenkontaktstelle entspricht. Für eine variable Einsetzbarkeit ist bevorzugt, wenn dieser Abstand einstellbar ausgeführt ist. Dazu können die Sensoren zum Beispiel verschieblich gehalten sein.

Vorzugsweise ist der Feldsensor mit einem Hallsensor und/oder mit einer elektrischen Spule ausgebildet. Es wird also vorgeschlagen, den Feldsensor als Magnetsensor auszubilden. Hallsensoren und elektrische Spulen zum Messen eines Magnetfeldes sind grundsätzlich bekannt. Diese beiden Sensortypen sind besonders robust und ausfallsicher.

Vorzugsweise weist die Sensoreinrichtung eine Vielzahl von Feldsensoren auf, um mehrere Prüfstellen des Batteriemoduls gleichzeitig jeweils mit einem Feldsensor zu prüfen, wobei die Vielzahl der Feldsensoren an einer Sensorhalterung des Positioniersystems befestigt sind. Die Sensorhalterung ist verfahrbar entlang der Längsachse, der Querachse und der Hochachse ausgebildet, um die Vielzahl der Feldsensoren gleichzeitig zu verfahren. Es wird also vorgeschlagen, eine Vielzahl von Messköpfen zu verwenden, um parallel und gleichzeitig mehrere Prüfstellen zu prüfen. Damit wird die Dauer des Prüfverfahrens des Batteriemoduls reduziert. Die Sensorhalterung ist eine Halterung oder Tragkonstruktion, an der die Feldsensoren bzw. die Sensoreinrichtung befestigt ist. Die Sensoreinrichtung ist mit der Vielzahl von Feldsensoren also fest mit der Sensorhalterung mechanisch verbunden, so dass sich eine Bewegung der Sensorhalterung unmittelbar auf die Sensoreinrichtung auswirkt. Die Vielzahl der Feldsensoren, die an der Sensorhalterung befestigt sind, werden also gleichzeitig bewegt. Die Sensorhalterung ist Teil des Sensorpositioniersystems und somit verfahrbar ausgebildet, wie zuvor beschrieben. Dabei kann bevorzugt vorgesehen sein, dass die Feldsensoren einer Sensoreinrichtung relativ zueinander abstandsveränderlich an der Sensorhalterung angeordnet sind. Dadurch lässt sich die Sensoreinrichtung für verschiedene Batteriemodule flexibel einsetzen, indem die Feldsensoren so zueinander beanstandet angeordnet werden, dass sie dem Muster der zu prüfenden Kontaktstellen entsprechen. Auf diese Weise kann die Einrichtung für unterschiedliche Arten von Batteriemodulen angepasst eingesetzt werden.

Vorzugsweise weist das Positioniersystem mehrere Sensorhalterungen auf, die jeweils unabhängig voneinander entlang einer Längsasche, einer Querachse und einer Hochachse verfahrbar ausgebildet sind, und wobei an jeder Sensorhalterung eine Vielzahl von Feldsensoren befestigt sind, um mehrere Prüfstellen des Batteriemoduls zu prüfen. Es wird also vorgeschlagen, dass das Positioniersystem mehrere unabhängig voneinander bewegbare Sensorhalterungen aufweist, an denen jeweils eine Vielzahl von Feldsensoren bzw. Sensorköpfen befestigt sind. Beispielsweise können unabhängig voneinander verfahrbare Sensorhalterungen mit einer Vielzahl von Feldsensoren verwendet werden. So können gleichzeitig eine Vielzahl von Prüfstellen unabhängig voneinander geprüft werden. Damit wird die Dauer des Prüfverfahrens des Batteriemoduls reduziert. Die Vielzahl der Feldsensoren sind dabei beabstandet zueinander angeordnet und an der Halterung fixiert und weisen vorzugsweise einen Abstand zueinander auf, der auf einen Abstand der Batteriezellen abgestimmt ist. Es wird also vorgeschlagen, dass ein Abstandsmaß der Feldsensoren zueinander zu einem Abstandsmaß der Batteriezellen zueinander passt. Der Abstand der Feldsensoren wird also auf den Abstand der Batteriezellen angepasst. Wie bereits zuvor angegeben ist vorteilhaft, wenn dieser Abstand veränderbar ist, um unterschiedliche Batteriemodule prüfen zu können.

Vorzugsweise umfasst die Prüfvorrichtung eine Auswertungseinrichtung zur Auswertung des im Bereich der Prüfstelle erfassten Feldes, wobei die Auswertungseinrichtung dazu eingerichtet ist, auf Basis des erfassten Feldes eine Kontaktierungsqualität festzustellen und/oder optisch anzuzeigen. Vorzugsweise weist die Auswertungseinrichtung eine optische Anzeige auf, mit welcher ein Auswertungsergebnis anzeigbar ist. Es wird also vorgeschlagen, eine Auswertungseinrichtung vorzusehen, die die Sensorsignale auswertet. Dazu kann die Auswertungseinrichtung einen Auswertungsalgorithmus aufweisen, der als Computerprogramm in der Auswertungseinrichtung implementiert ist. Das Ergebnis der Auswertung kann ein Kennwert für die Kontaktierungsqualität sein. Wenn der bestimmte Kennwert z.B. einen vorbestimmten Schwellenwert unterschreitet, wird auf eine fehlerhafte Kontaktstelle geschlossen und ein Fehler angezeigt oder gemeldet.

In einer besonders bevorzugten Ausführungsform ist die Auswertungseinrichtung dazu eingerichtet, eine Kontaktierungsqualität der Zellkontaktierung an der Prüfstelle oder an mehreren Prüfstellen durch Auswertung der erfassten Flussdichte und/oder der erfassten Feldstärke zu bestimmen. Die Flussdichte und Feldstärke beziehen sich dabei sowohl auf die des Magnetfeldes wie auch auf das elektrische Feld. Es wird also vorgeschlagen, dass die Auswertungseinrichtung die Flussdichte und/oder die Feldstärke signal- oder datentechnisch auswertet. Ein Auswerten kann dabei ein Vergleichen oder eine Signalanalyse umfassen. Die erfasste Flussdichte und/oder Feldstärke kann dann mit anderen Messungen oder Referenzwerten in Beziehung gesetzt werden, um auf die Qualität der Zellkontaktierung zu schließen.

Vorzugsweise weist die Auswertungseinrichtung eine Vergleichsdatenbank auf, in der Vergleichsdaten hinterlegt sind, und die Auswertungseinrichtung ist dazu eingerichtet, die erfassten Flussdichten und/oder Feldstärken mit den Vergleichsdaten zu vergleichen, um auf die Kontaktierungsqualität zu schließen. Es versteht sich dabei, dass die Auswertungseinrichtung dazu einen Datenspeicher aufweist. Die Vergleichsdatenbank umfasst beispielsweise Vergleichswerte für die Flussdichten und/oder Feldstärken. In der Auswertungseinrichtung ist beispielsweise ein Computerprogramm oder ein Algorithmus hinterlegt, der die erfasste Feldstärke und/oder Flussdichte mit der Datenbank abgleicht.

Als ein weiterer erfindungsgemäßer Aspekt wird ein Verfahren zum Prüfen einer Zellkontaktierung von Batteriezellen eines Batteriemoduls vorgeschlagen. Das Verfahren umfasst die Schritte: Bereitstellen eines Batteriemoduls, wobei das Batteriemodul mehrere elektrisch parallel über ein Kontaktierungssystem verbundene Batteriezellen aufweist; Positionieren einer Sensoreinrichtung an wenigstens einer Prüfstelle des Batteriemoduls mit einem Sensorpositioniersystem; Erzeugen eines Batteriezellenstroms zwischen Kontaktstellen der Batteriezellen durch Entladen der Batteriezellen oder durch Laden der Batteriezellen; Erfassen eines Feldes im Bereich der wenigstens einen Prüfstelle, das durch den erzeugten Batteriezellenstrom erzeugt wird; und Auswerten des erfassten Feldes zur Bestimmung einer Kontaktierungsqualität der Zellkontaktierung an der wenigstens einen Prüfstelle.

Das bereitgestellte Batteriemodul kann dabei vorgeladen oder ungeladen sein. Zudem können Batteriezellen des Batteriemoduls auch zusätzlich in Serie geschaltet sein, um eine vorbestimmte Batterieausgangsspannung des Batteriemoduls einzustellen. Das Sensorpositioniersystem ist ausgebildet, wie zuvor oder nachfolgend beschrieben. Das Erzeugen des Batteriezellenstroms wird mit einer Stromerzeugungsschaltung durchgeführt, wie zuvor oder nachfolgend beschrieben. Das Erfassen eines Feldes im Bereich der wenigstens einen Prüfstelle erfolgt mit einer Sensoreinrichtung mit wenigstens einem Feldsensor, wie zuvor oder nachstehend beschrieben. Das Feld bezieht sich auf ein Magnetfeld und/oder ein elektrisches Feld.

Vorzugsweise wird das Verfahren mittels einer Vorrichtung zum Prüfen einer Zellkontaktierung von Batteriezellen eines Batteriemoduls nach einer der vorstehenden Ausführungsformen ausgeführt.

Die zur Prüfvorrichtung beschriebenen Erläuterungen, Definitionen und Vorteile finden analog Anwendung für das zuvor beschriebene Prüfverfahren.

Die vorliegende Erfindung wird nun nachfolgend exemplarisch anhand von Ausführungsbeispielen unter Bezugnahme auf die begleitenden Figuren näher erläutert, wobei für gleiche oder ähnliche Baugruppen dieselben Bezugszeichen verwendet werden:
- Fig. 1: zeigt schematisch eine perspektivische Ansicht einer erfindungsgemäßen Prüfvorrichtung in einer Ausführungsform.
- Fig. 2: zeigt schematisch eine Batteriezelle eines Batteriemoduls und eine Positionierung eines Feldsensors im Bereich einer Prüfstelle.
- Fig. 3: zeigt schematisch eine Batteriezelle eines Batteriemoduls mit einer Stromerzeugungsschaltung und einer Auswertungseinrichtung in einer Ausführungsform.
- Fig. 4: zeigt schematisch eine Batteriezelle eines Batteriemoduls mit einer Stromerzeugungsschaltung und einer Auswertungseinrichtung in einer weiteren Ausführungsform.
- Fig. 5: zeigt schematisch eine Batteriezelle eines Batteriemoduls und einen Feldsensor mit zwei Sensoren in einer Ausführungsform.
- Fig. 6: zeigt schematisch eine Batteriezelle eines Batteriemoduls und mehrere Prüfstellen im Bereich der Batteriezelle.
- Fig. 7: zeigt schematisch ein Sensorpositioniersystem zum Positionieren einer Sensoreinrichtung mit einer Vielzahl von Feldsensoren und zwei unabhängig voneinander verfahrbaren Sensorhalterungen.
- Fig. 8: zeigt schematisch ein Ablaufdiagramm des erfindungsgemäßen Prüfverfahrens.

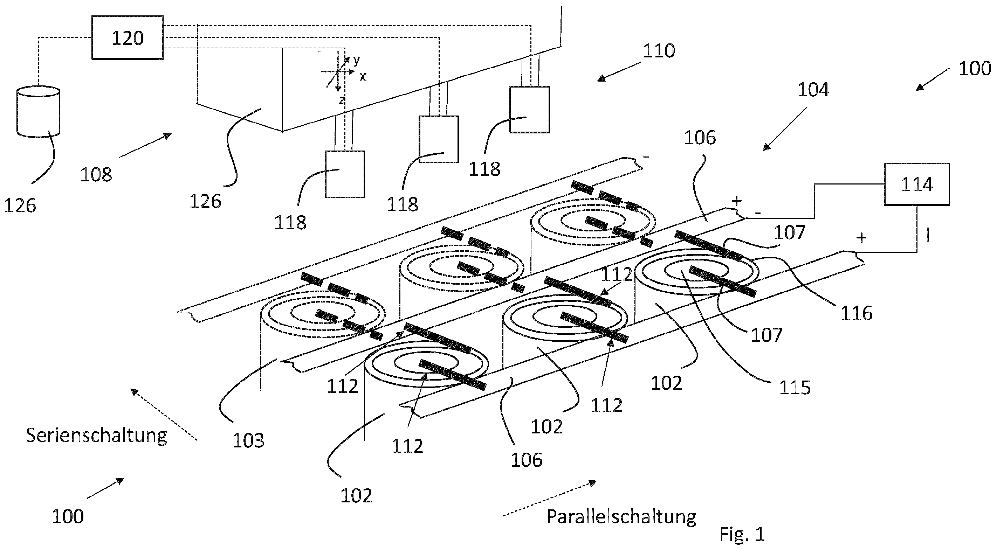

Die Figur 1 zeigt eine Vorrichtung 100 zum Prüfen einer Zellkontaktierung von Batteriezellen 102 eines Batteriemoduls 104, bei der mehrere Batteriezellen 102 des Batteriemoduls 104 elektrisch parallel über ein Kontaktierungssystem 106, 107 verbunden sind. Das Kontaktierungssystem ist wenigstens aus einer ersten Stromschiene 106 für die positiven Anschlussstellen 115 (Pluspol) der Batteriezellen 102 und aus einer zweiten Stromschiene 106 für die negativen Anschlussstellen 116 der Batteriezellen 102 ausgebildet. Die Stromschienen 106 werden über Verbindungsleiter 107 mit der Batteriezelle elektrisch kontaktiert, d.h. elektrisch leitend verbunden. Wie der Figur 1 zu entnehmen ist, sind die drei Batteriezellen 102 elektrisch parallelgeschaltet. Die Kontaktstellen 115, also die Pluspole der Batteriezellen 102, sind jeweils über einen Verbindungsleiter 107 mit einer Stromschiene 106 verbunden. Zudem sind die Kontaktstellen 116, also die Minuspole der Batteriezellen 102, ebenfalls über einen Verbindungsleiter 107 mit einer Stromschiene 106 verbunden. Die drei gezeigten Batteriezellen 102 stehen beispielhaft für eine Vielzahl von Batteriezellen des Batteriemoduls 104. Zudem ist in der Figur 1 gestrichelt angedeutet, dass noch weitere Batteriezellen 103 Teil des Batteriemoduls 104 sein können, die beispielsweise in Serie zu den Batteriezellen 102 geschaltet sind. Die Serienschaltung der Batteriezellen 103 wird vorgenommen, um eine gewünschte Ausgangsspannung am Batteriemodul 104 einzustellen, da sich durch die Reihenschaltung der Batteriezellen 102 und 103 die Spannungen der einzelnen Batteriezellen addieren.

Das Kontaktierungssystem ist also aus Stromschienen 106 und Verbindungsleitern 107 ausgebildet, und es dient dem Zweck, die Batteriezellen 102 und gegebenenfalls die weiteren Batteriezellen 103 elektrisch leitend zu verbinden.

Die Kontaktstellen 115 und 116, also der Pluspol bzw. Minuspol der Batteriezellen 102, sind auf der gleichen Seite angeordnet. Es ist auch bekannt, dass Pluspol 115 und Minuspol 116 auf gegenüberliegenden Seiten der Batteriezellen 102 angeordnet sind, wie es von handelsüblichen Batterien bekannt ist.

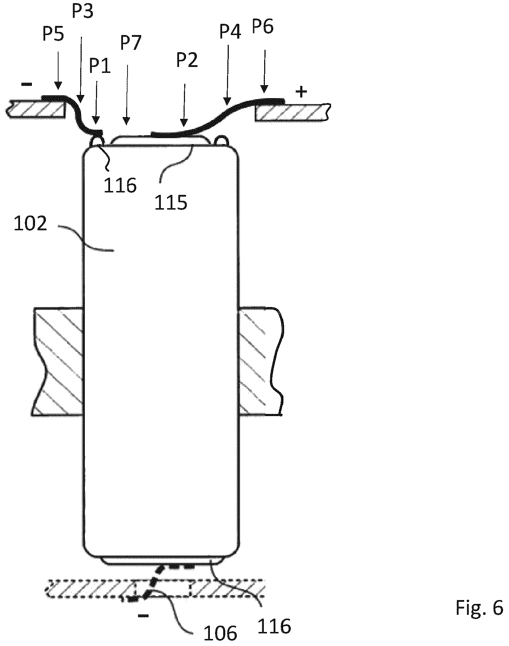

Die Prüfvorrichtung 100 umfasst zudem ein Sensorpositioniersystem 108 zum Positionieren einer Sensoreinrichtung 110 an einer Vielzahl von Prüfstellen 112 des Batteriemoduls 104, wobei das Sensorpositioniersystem zum Positionieren der Sensoreinrichtung verfahrbar entlang einer Längsasche X, einer Querachse Y und einer Hochachse Z ausgebildet ist. Die Prüfstellen 112 sind genauer in der Figur 6 veranschaulicht.

Die Sensoreinrichtung 110 weist eine Vielzahl von Feldsensoren 118 auf, um mehrere Prüfstellen 112 des Batteriemoduls 104 jeweils mit einem Feldsensor 118 gleichzeitig zu prüfen. Die Vielzahl der Feldsensoren 118 sind an einer Sensorhalterung 126 des Positioniersystems 108 befestigt. Die Sensorhaltung 126 ist entlang einer Längsachse X, der Querachse Y und der Hochachse Z verfahrbar ausgebildet, um die Vielzahl der Feldsensoren 118 gleichzeitig zu verfahren. Die Sensorhalterung 126 kann also abgesenkt oder angehoben werden, sie kann nach rechts und links bewegt werden und sie kann vorwärts und rückwärts bewegt werden. Dies ist mit dem angedeuteten Koordinatensystem veranschaulicht. Die Vielzahl der Feldsensoren 118 sind dabei beabstandet zueinander angeordnet und an der Halterung 126 fixiert und weisen einen Abstand zueinander auf, der auf einen Abstand der Batteriezellen 102 abgestimmt ist. Es wird also vorgeschlagen, dass ein Abstandsmaß der Feldsensoren 118 zueinander zu einem Abstandsmaß der Batteriezellen 102 zueinander passt, damit gleichzeitig mehrere Prüfstellen 112 angefahren werden können. Beispielsweise können mit den drei gezeigten Feldsensoren 118 die drei gezeigten Batteriezellen 102 gleichzeitig geprüft werden.

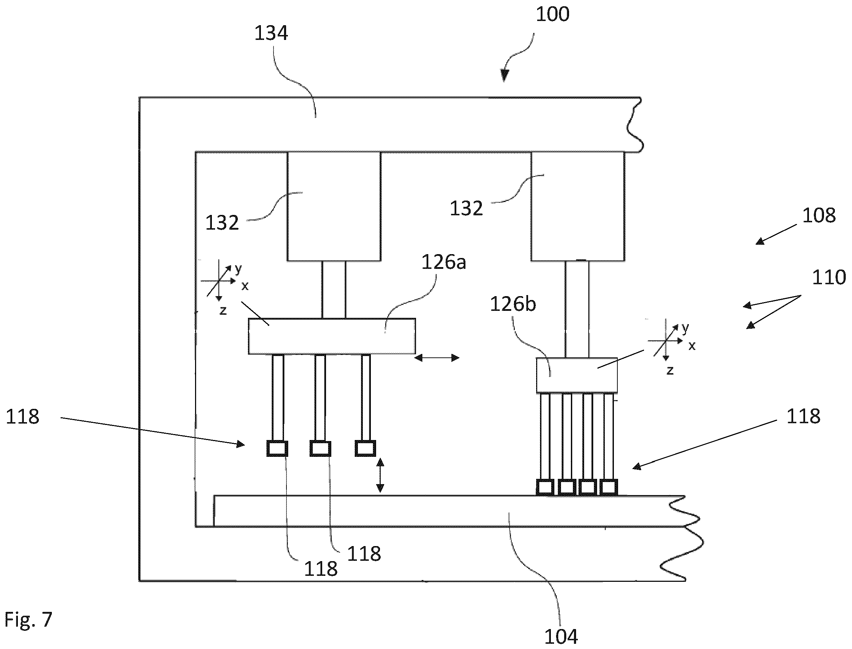

In der Figur 1 ist zwar nur eine Sensorhalterung 126 gezeigt, das Positioniersystem 108 kann aber auch mehrere Sensorhalterungen 126 aufweisen, die jeweils unabhängig voneinander entlang der Längsasche X, einer Querachse Y und einer Hochachse Z verfahrbar ausgebildet sind, und an jeder der Sensorhalterungen kann eine Vielzahl von Feldsensoren 118 befestigt sein, um mehrere Prüfstellen 112 des Batteriemoduls 104 zu prüfen. Dies ist beispielsweise in der Figur 7 dargestellt.

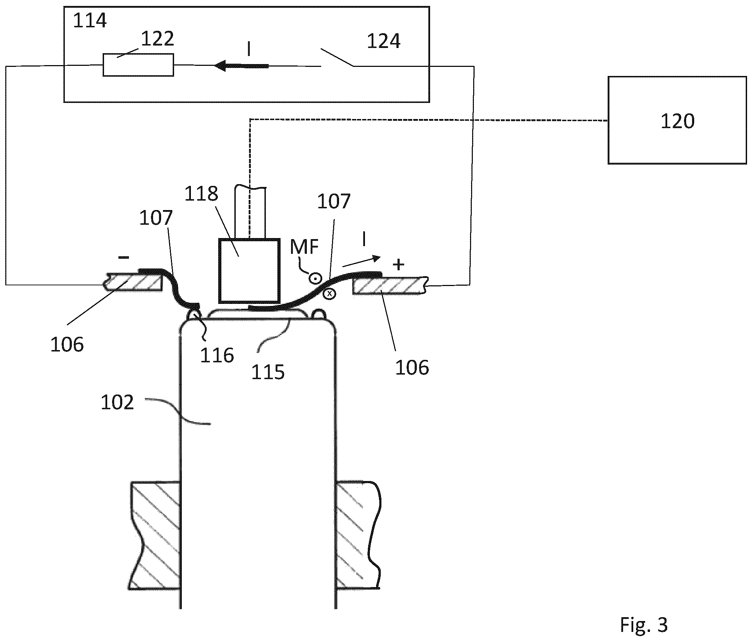

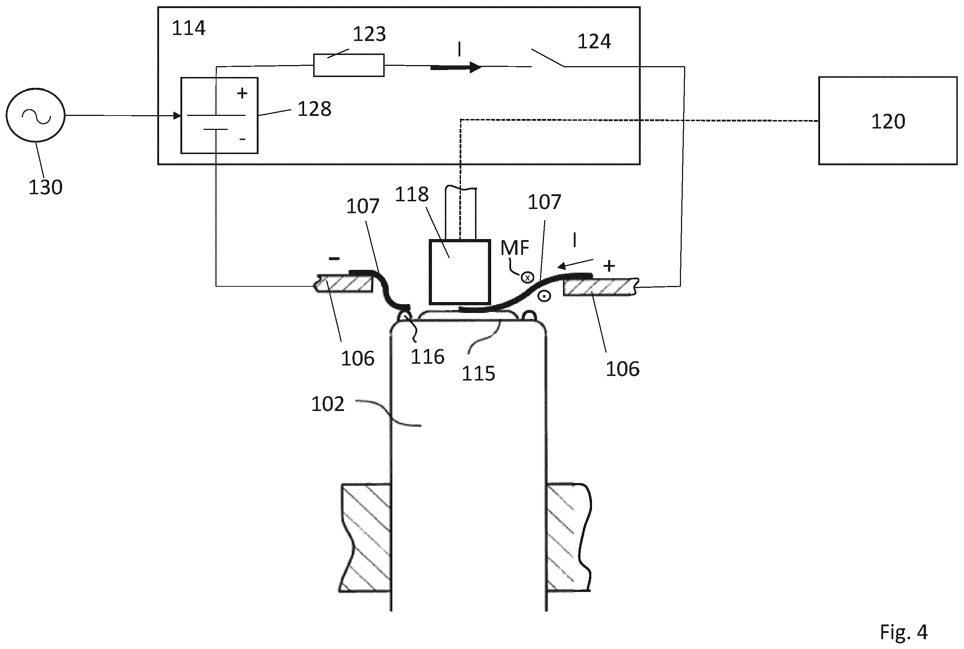

Die Prüfvorrichtung 100 umfasst zudem eine Stromerzeugungsschaltung 114 zum Erzeugen eines Batteriezellenstroms, wobei der Batteriezellenstrom I ein Entladestrom aus der Batteriezelle 102 ist oder ein Ladestrom in die Batteriezelle 102. Die Stromerzeugungsschaltung 114 ist beispielsweise in der Figur 3 oder 4 detaillierter gezeigt. Die Stromerzeugungsschaltung 114 ist so mit den Batteriezellen verbunden, dass sich der Batteriezellenstrom I einstellt. In der Figur 1 ist die Stromerzeugungsschaltung 114 an die positive und negative Stromschiene 106 angeschlossen.

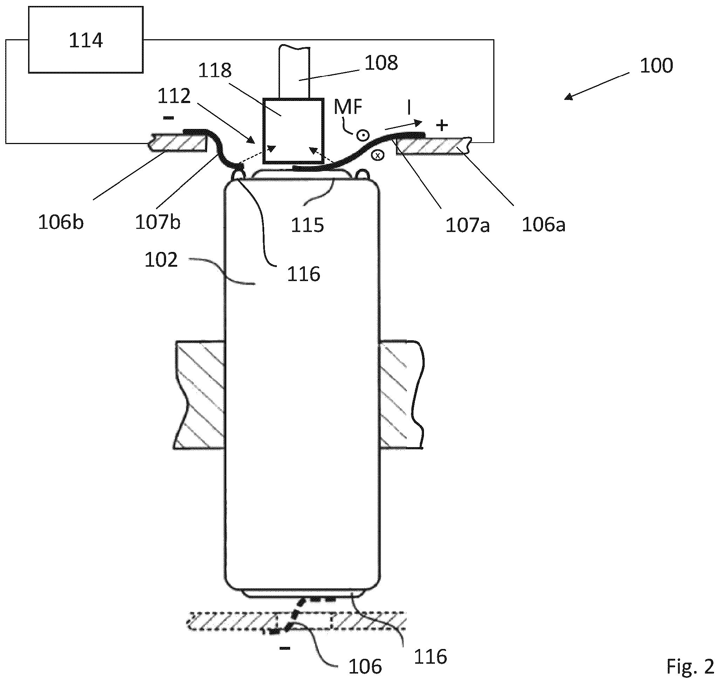

Die Prüfvorrichtung 100 umfasst zudem die Sensoreinrichtung 110, die mit wenigstens einem Feldsensor 118 ausgebildet ist. In der Figur 1 sind beispielhaft drei Feldsensoren 118 gezeigt. Der Feldsensor 118 ist nach Positionierung der Sensoreinrichtung 110 an einer Prüfstelle 112 dazu eingerichtet, ein Feld im Bereich der Prüfstelle 112 zu erfassen, das durch den mit der Stromerzeugungsschaltung 14 erzeugten Batteriezellenstrom I erzeugt wird. Dieses Prinzip ist in den Figuren 2 bis 6 detaillierter veranschaulicht.

Die Sensoreinrichtung 110 ist beispielsweise mit dem Feldsensor 118 dazu eingerichtet, eine magnetische Flussdichte B und/oder eine magnetische Feldstärke H zu erfassen, und/oder die Sensoreinrichtung 110 ist mit dem Feldsensor 118 dazu eingerichtet, eine elektrische Flussdichte D und/oder eine elektrische Feldstärke E zu erfassen.

Die Prüfvorrichtung 100 ist mit einer Auswertungseinrichtung 120 dazu eingerichtet, die erfasste magnetische Flussdichte B und/oder die magnetische Feldstärke H des erfassten Feldes auszuwerten und/oder die erfasste elektrische Flussdichte D und/oder die elektrische Feldstärke E des erfassten Feldes auszuwerten.

Die Vorrichtung 100 weist also eine Auswertungseinrichtung 120 zur Auswertung des im Bereich der Prüfstelle 112 erfassten Feldes auf.

Die Auswertungseinrichtung 120 ist dazu eingerichtet, eine Kontaktierungsqualität der Zellkontaktierung an der Prüfstelle 112 oder an mehreren Prüfstellen 112 durch Auswertung der erfassten Flussdichte B, D und/oder der erfassten Feldstärke H, E zu bestimmen.

Die Auswertungseinrichtung 120 kann zudem eine Vergleichsdatenbank 126 aufweisen, in der Vergleichsdaten hinterlegt sind, um die erfassten Flussdichten und/oder Feldstärken mit den Vergleichsdaten zu vergleichen und um auf die Kontaktierungsqualität zu schließen. Wird zum Beispiel keine oder nur eine niedrige Feldstärke gemessen, kann von einem Kontaktfehler ausgegangen werden.

Der Feldsensor 118 ist beispielsweise zum Erfassen eines Magnetfeldes mit einem HallSensor und/oder mit einer elektrischen Spule ausgebildet.

Nicht in der Figur 1 ist eine Steuereinrichtung gezeigt, die zum Steuern des Sensorpositioniersystems und zum Ansteuern der Stromerzeugungsschaltung eingerichtet ist und die datentechnisch mit einer Auswertungseinrichtung und der Sensoreinrichtung verbunden ist. Die Steuereinrichtung ist dazu vorgesehen und eingerichtet, das Prüfverfahren zu koordinieren, also das Anfahren der Prüfstellen mit dem Positioniersystem 108, das Erzeugen des Batteriestroms I mit der Stromerzeugungsschaltung 114, den Messvorgang mit der Sensoreinrichtung 110 und den Auswertungsvorgang mit der Auswertungseinrichtung 120 steuerungstechnisch zu koordinieren.

Die Figur 2 zeigt schematisch eine Batteriezelle 102 eines Batteriemoduls 104 und eine Positionierung eines Feldsensors 118 im Bereich einer Prüfstelle. Der Feldsensor 118 wurde also mit dem Sensorpositioniersystems 118 im Bereich der Prüfstelle 112 positioniert. Die Prüfstelle 112 ist in dem gezeigten Fall eine Prüfstelle, die örtlichen zwischen der Kontaktstelle 115 und 116 liegt. Diese Prüfstelle ist vorteilhaft, da sowohl ein Feld im Bereich der Kontaktstelle 115 sowie auch im Bereich der Kontaktstelle 116 erfassbar ist. Dies ist mit den beiden gestrichelten Pfeilen veranschaulicht.

In der Figur 2 ist eine Stromerzeugungsschaltung gezeigt. Mit der Stromerzeugungsschaltung 114 wird ein Batteriezellenstrom I erzeugt, der in dem gezeigten Beispiel von dem Pluspol der Batterie 102 zum Minuspol 116 der Batteriezelle 102 fließt. Die Stromerzeugungsschaltung 114 stellt also einen geschlossenen Stromkreis zwischen den beiden Kontaktstellen 115 und 116 her. Aufgrund des Stromflusses wird ein magnetisches Feld MF erzeugt. Es wird ein ringförmiges Magnetfeld um den Verbindungsleiter 107 erzeugt, da dieser ein stromdurchflossener Leiter ist. Es bildet sich nach der Rechte-Hand-Regel ein Magnetfeld aus, das in der Figur 2 schematisch als MF verdeutlicht ist. Das mit dem Batteriezellenstrom I erzeugte Magnetfeld ist dabei nur an dem Verbindungsleiter 107 veranschaulicht, der mit der positiven Stromschiene 106 verbunden ist.

Die Figur 2 veranschaulicht zudem, dass der Minuspol der Batteriezelle 102 auch auf der Unterseite der Batteriezelle angeordnet sein kann.

Zudem ist in der Figur 2 zu erkennen, dass, um die Batteriezelle 102 mit Stromschienen 106 zu verbinden, bei Verwendung von Verbindungsleitern 107 vier elektrische Verbindungen herzustellen sind. Der erste Verbindungsleiter 107a ist an einer ersten Seite mit dem Anodenkontakt 115 (Pluspol) der Batteriezelle 102 elektrisch verbunden und an einer zweiten Seite ist er mit der Stromschiene 106a elektrisch verbunden. Die Verbindungspunkte können beispielsweise lasergeschweißt sein oder ultraschallgeschweißt. An der Stromschiene 106a sind parallel weitere Batteriezellen mit ihren Anodenkontakten geschaltet, wie z. B. in der Figur 1 gezeigt. Diese Art zu kontaktieren, wird analog für den zweiten Verbindungsleiter 107b durchgeführt, um den Kathodenkontakt 116 (Minuspol) und die Stromschiene 106b für den Minuspol der Batteriezelle 102 elektrisch zu verbinden. Insgesamt ist die Batteriezelle 102 also an vier Verbindungsstellen elektrisch kontaktiert worden. Diese Verbindungsstellen sind dahingehend zu prüfen, ob sie elektrisch leitfähig sind. Es wird also geprüft, ob ein ordnungsgemäß arbeitendes Batteriemodul bereit ist, bei denen alle Batteriezellen ordnungsgemäß kontaktiert sind.

Figur 3 zeigt eine Stromerzeugungsschaltung 114 in einer Ausführungsform als Entladungsschaltung. Die Batteriezelle 102, die beispielhaft für eine Vielzahl von weiteren Batteriezellen ist, ist elektrisch vorgeladen. Es ist dabei ausreichend, die Batteriezelle 102 nur teilweise aufzuladen bzw. vorzuladen, beispielsweise auf 10% bis 20% der maximalen Speicherkapazität. Die Stromerzeugungsschaltung 114 ist als Entladungsschaltung mit einem Lastwiderstand 122 zum Entladen der vorgeladenen Batteriezellen über das Kontaktierungssystem 106 ausgebildet, um den Batteriezellenstrom als Entladestrom zwischen Kontaktstellen 115, 116 der Batteriezellen 102 zu erzeugen. Wird der Schalter 124 geschlossen, der steuerbar ausgebildet ist, fließt ein Strom I, nämlich der Batteriestrom bzw. Batteriezellenstrom, da ein geschlossener Stromkreis vorliegt. Der Batteriezellenstrom erzeugt ein Magnetfeld MF, dass mit dem Feldsensor 118 detektierbar ist. Wäre einer der vier Verbindungsstellen, die zur Figur 2 beschrieben wurden, beschädigt oder nichtleitend, wäre der Stromkreis entsprechend nicht geschlossen. Wird im Bereich der Prüfstelle dann also kein Feld gemessen, ist einer der vier Kontakte defekt. Wird nur ein geringes Magnetfeld gemessen, kann von einer schlecht leitenden elektrischen Verbindung an einer der vier genannten Verbindungsstellen ausgegangen werden. Zudem ist in der Figur 3 die Auswertungseinrichtung 120 veranschaulicht, die datentechnisch mit dem Sensorkopf 118 verbunden ist.

Figur 4 zeigt eine Stromerzeugungsschaltung 114 in einer Ausführungsform als Ladeschaltung. Die Batteriezelle 102, die beispielhaft für eine Vielzahl von weiteren Batteriezellen ist, ist elektrisch ungeladen oder teilweise geladen, also nicht vollständig geladen. Die Stromerzeugungsschaltung 114 weist eine Gleichstromquelle 128 auf, mit der der Batteriezellenstrom I als Ladestrom erzeugt wird. Die Gleichstromquelle 128 kann beispielsweise aus dem elektrischen Versorgungsnetz 130 versorgt werden. Es versteht sich, dass die Gleichstromquelle 128 einen Gleichrichter umfasst, da das elektrische Versorgungsnetz 130 ein Wechselstromnetz ist, denn die Batteriezellen 102 werden bekannter Weise mit einem Gleichstrom und einer Gleichspannung geladen. Der Ladestrom bezeichnet die Stromstärke, mit der ein Akku bzw. die Batterie geladen wird. Zudem weist die Stromerzeugungsschaltung 114 optional einen Ladewiderstand 123 auf, um den Ladestrom zu begrenzen. Die Stromerzeugungsschaltung 114 ist also zum Laden der Batteriezellen 102 über das Kontaktierungssystem 106 ausgebildet, um den Batteriezellenstrom als Ladestrom in die Batteriezellen 102 einzuspeisen. Wird der Schalter 124 geschlossen, der steuerbar ausgebildet ist, fließt ein Ladestrom I, nämlich der Batteriestrom bzw. Batteriezellenstrom, da ein geschlossener Stromkreis vorliegt. Der Batteriezellenstrom I erzeugt ein Magnetfeld MF, dass mit dem Feldsensor 118 detektierbar ist. Wäre einer der vier Verbindungsstellen, die zur Figur 2 beschrieben wurden, beschädigt oder nichtleitend, wäre der Stromkreis entsprechend nicht geschlossen. Wird im Bereich der Prüfstelle dann beim Laden kein Feld gemessen, ist einer der vier Kontakte defekt. Wird nur ein geringes Magnetfeld gemessen, kann von einer schlecht leitenden elektrischen Verbindung an einer der vier genannten Verbindungsstellen ausgegangen werden.

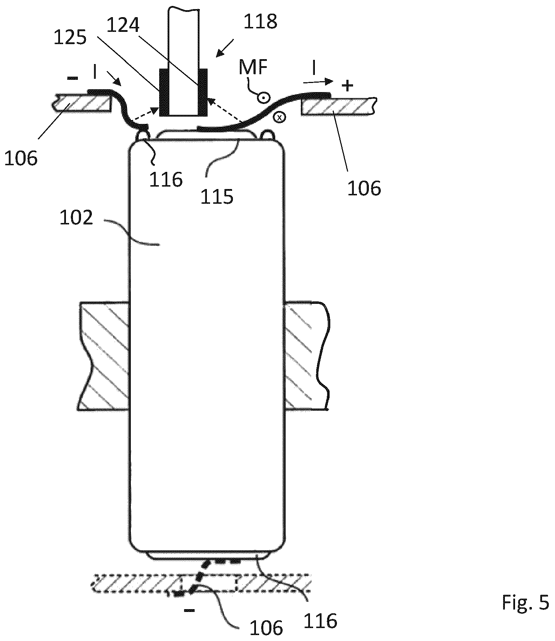

Figur 5 zeigt einen Feldsensor 118 der mit zwei Sensoren 124, 125 ausgebildet ist. Der Sensor 124 ist zum Erfassen eines im Bereich einer Anodenkontaktstelle 115 der Batteriezelle 102 erzeugten Feldes MF ausgebildet und der anderer Sensoren 125 ist zum Erfassen eines im Bereich einer Kathodenkontaktstelle 116 erzeugten Feldes MF ausgebildet. Das Feld MF wird also gleichzeitig an der Anodenkontaktstelle und der Kathodenkontaktstelle der Batteriezelle geprüft.

Figur 6 zeigt beispielhaft, wo geeignete Prüfstellen an der Batteriezelle 102 vorgesehen sein können. Eine Prüfstelle ist ganz grundsätzlich eine Stelle im Bereich der zu prüfenden Batteriezelle 102, an der das durch den Batteriezellenstrom I erzeugte Feld MF messbar ist. Geeignete Prüfstellen sind beispielsweise Stellen in unmittelbarer Nähe der Kontaktstellen der Batteriezellen, also im Bereich der Anoden- und/oder der Kathodenanschlüsse der Batteriezellen, also z.B. die Prüfstellen P1 und/oder P2. Eine weitere geeignete Prüfstelle ist im Bereich der Verbindungsleiter, die die Stromschiene und die Batteriezellen elektrisch verbinden, also z.B. die Prüfstellen P3 und/oder P4. Zudem ist eine weitere geeignete Prüfstelle eine Stelle in dem Bereich, wo ein Verbindungsleiter der Batteriezelle mit der Stromschiene verbunden ist, also z.B. die Prüfstellen P5 und P6. Zudem kann eine Prüfstelle P7 auch zwischen dem Anoden- und dem Kathodenanschluss vorgesehen sein.

Figur 7 zeigt schematisch ein Sensorpositioniersystem 108 zum Positionieren einer Sensoreinrichtung 110 mit einer Vielzahl von Feldsensoren 118 und zwei unabhängig verfahrbaren Sensorhalterungen, die mit einer Antriebseinrichtung 134 verfahrbar ausgebildet sind.

Die gezeigte Sensoreinrichtung 110 weist eine Vielzahl von Feldsensoren 118 auf, um mehrere Prüfstellen 112 des Batteriemoduls 104 jeweils mit einem Feldsensor 118 gleichzeitig zu prüfen, wobei die Feldsensoren 118 an einer Sensorhalterung 126a des Positioniersystems 108 befestigt sind. Die Sensorhaltung 126a ist entlang der Längsachse X, der Querachse Y und der Hochachse Z verfahrbar ausgebildet, um die Vielzahl der Feldsensoren gleichzeitig zu verfahren.

Zudem ist in der Figur 7 auch gezeigt, dass das Positioniersystem 108 mehrere Sensorhalterungen 126a, 126b aufweist, die jeweils unabhängig voneinander entlang einer Längsasche X, einer Querachse Y und einer Hochachse Z verfahrbar ausgebildet sind, und wobei an jeder Sensorhalterung 126a, 126b eine Vielzahl von Feldsensoren 118 befestigt sind, um mehrere Prüfstellen 112 des Batteriemoduls 104 zu prüfen.

Zudem ist in der Figur 7 gezeigt, dass die Sensorhalterungen 126a und 126b mit einer Antriebseinrichtung 132 ausgebildet sind.

Um die Antriebseinrichtung und die Sensorhalterungen 126a und 126b zu tragen, kann eine Tragstruktur 134 vorgesehen sein, die aus einem strukturfesten Material ausgebildet ist.

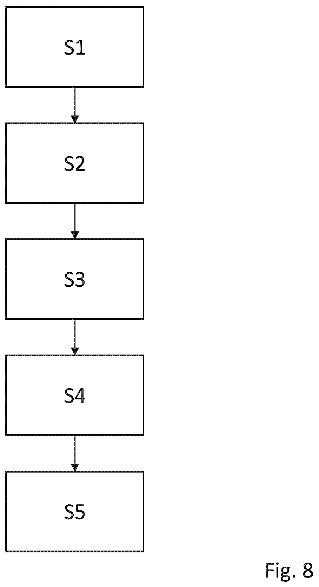

Die Figur 8 zeigt schematisch ein Verfahren zum Prüfen einer Zellkontaktierung von Batteriezellen 102 eines Batteriemoduls 104. Das Verfahren umfasst die Schritte:
S1: Bereitstellen eines Batteriemoduls 104, wobei das Batteriemodul 104 mehrere elektrisch parallel über ein Kontaktierungssystem 106 verbundene Batteriezellen 102 aufweist, wie beispielsweise in der Figur 1 gezeigt.
S2: Positionieren einer Sensoreinrichtung 110 an wenigstens einer Prüfstelle 112 des Batteriemoduls 104 mit einem Sensorpositioniersystem 108, wie beispielsweise in der Figur 1 oder 7 gezeigt.
S3: Erzeugen eines Batteriezellenstroms I zwischen Kontaktstellen 115, 116 der Batteriezellen 102 durch Entladen der Batteriezellen 102 oder Laden der Batteriezellen 102, wie beispielsweise in den Figuren 2 bis 4 gezeigt.
S4: Erfassen eines Feldes MF im Bereich der wenigstens einen Prüfstelle 112, das durch den erzeugten Batteriezellenstrom I erzeugt wird, wie beispielsweise in der Figur 3 bis 5 gezeigt.
S5: Auswerten des erfassten Feldes MF zur Bestimmung einer Kontaktierungsqualität der Zellkontaktierung an der wenigstens einen Prüfstelle 112, wie beispielsweise in der Figur 1, 3 oder 4 gezeigt.

### Bezugszeichenliste

- 100: Vorrichtung oder Prüfvorrichtung
- 102: Batteriezelle
- 104: Batteriemodul
- 106: Stromschiene
- 107: Verbindungsleiter
- 108: Sensorpositioniersystem
- 110: Sensoreinrichtung
- 112: Prüfstelle
- 114: Stromerzeugungsschaltung
- 115: Kontaktstelle (Pluspol)
- 116: Kontaktstelle (Minuspol)
- 118: Feldsensor
- 120: Auswertungseinrichtung
- 122: Lastwiderstand
- 124: Sensoren
- 126: Sensorhalterung
- 128: Gleichstromquelle
- 130: Versorgungsnetz
- 132: Antriebseinrichtung
- 134: Tragstruktur

## Patentansprüche

1. Vorrichtung (100) zum Prüfen einer Zellkontaktierung von Batteriezellen (102) eines Batteriemoduls (104), wobei mehrere Batteriezellen (102) des Batteriemoduls (104) elektrisch parallel über ein Kontaktierungssystem (106, 107) verbunden sind, die Vorrichtung umfasst:
- ein Sensorpositioniersystem (108) zum Positionieren einer Sensoreinrichtung (110) an einer Vielzahl von Prüfstellen (112) des Batteriemoduls (104), wobei das Sensorpositioniersystem zum Positionieren der Sensoreinrichtung verfahrbar entlang einer Längsachse (X), einer Querachse (Y) und einer Hochachse (Z) ausgebildet ist; und
- eine Stromerzeugungsschaltung (114) zum Erzeugen eines Batteriezellenstroms, wobei der Batteriezellenstrom (I) ein Entladestrom aus der Batteriezelle (102) oder ein Ladestrom in die Batteriezelle (102) ist, wobei
- die Sensoreinrichtung (110) mit wenigstens einem Feldsensor (118) ausgebildet ist, wobei der Feldsensor (118) dazu eingerichtet ist, nach Positionierung der Sensoreinrichtung an einer der Prüfstellen (112) ein Feld im Bereich der Prüfstelle (112) zu erfassen, das durch den mit der Stromerzeugungsschaltung (114) erzeugten Batteriezellenstrom (I) erzeugt wird, der Feldsensor (118) wenigstens zwei Sensoren (124,125) aufweist, und wobei die Vorrichtung zudem
- eine Auswertungseinrichtung aufweist zur Auswertung des im Bereich der Prüfstelle erfassten Feldes **dadurch gekennzeichnet, dass** die Auswertungseinrichtung dazu eingerichtet ist, eine Kontaktierungsqualität der Zellkontaktierung an der Prüfstelle oder an mehreren Prüfstellen durch Auswertung der erfassten Flussdichte und/oder der erfassten Feldstärke zu bestimmen, wobei einer der Sensoren (124) zum Erfassen eines im Bereich einer Anodenkontaktstelle (115) der Batteriezelle (102) erzeugten Feldes ausgebildet ist, und ein anderer der Sensoren (125) zum Erfassen eines im Bereich einer Kathodenkontaktstelle (116) erzeugten Feldes ausgebildet ist, insbesondere um gleichzeitig das Feld an der Anodenkontaktstelle und der Kathodenkontaktstelle der Batteriezelle zu prüfen.

2. Vorrichtung (100) nach Anspruch 1, wobei
- die Sensoreinrichtung (110) mit dem Feldsensor (118) dazu eingerichtet ist, eine magnetische Flussdichte (B) und/oder eine magnetische Feldstärke (H) zu erfassen, und wobei die Vorrichtung (100) mit einer Auswertungseinrichtung (120) dazu eingerichtet ist, die erfasste magnetische Flussdichte (B) und/oder die magnetische Feldstärke (H) des erfassten Feldes auszuwerten; und/oder
- die Sensoreinrichtung (110) mit dem Feldsensor (118) dazu eingerichtet ist, eine elektrische Flussdichte (D) und/oder eine elektrische Feldstärke (E) zu erfassen, wobei die Vorrichtung (100) mit einer Auswertungseinrichtung (120) dazu eingerichtet ist, die erfasste elektrische Flussdichte (D) und/oder die elektrische Feldstärke (E) des erfassten Feldes auszuwerten.

3. Vorrichtung (100) nach Anspruch 1 oder 2, wobei die Batteriezellen (102) elektrisch vorgeladen sind und die Stromerzeugungsschaltung (114) als Entladungsschaltung mit einem Lastwiderstand (122) zum Entladen der vorgeladenen Batteriezellen über das Kontaktierungssystem (106) ausgebildet ist, um den Batteriezellenstrom als Entladestrom zwischen Kontaktstellen (115, 116) der Batteriezellen (102) zu erzeugen.

4. Vorrichtung (100) nach einem der vorstehenden Ansprüche, wobei die Batteriezellen (102) elektrisch aufladbar sind und die Stromerzeugungsschaltung (114) als Ladeschaltung zum Laden der Batteriezellen (102) über das Kontaktierungssystem (106) ausgebildet ist, um den Batteriezellenstrom als einen Ladestrom zwischen Kontaktstellen (115, 116) der Batteriezellen (102) zu erzeugen.

5. Vorrichtung (100) nach einem der vorstehenden Ansprüche, wobei der Feldsensor (118) mit einem Hall-Sensor und/oder mit einer elektrischen Spule ausgebildet ist.

6. Vorrichtung (100) nach einem der vorstehenden Ansprüche, wobei die Sensoreinrichtung (110) eine Vielzahl von Feldsensoren (118) aufweist, um mehrere Prüfstellen (112) des Batteriemoduls (104) jeweils mit einem Feldsensor (118) gleichzeitig zu prüfen, wobei die Vielzahl der Feldsensoren (118) an einer Sensorhalterung (126) des Positioniersystems (108) befestigt sind, und die Sensorhaltung (126) entlang der Längsachse (X), der Querachse (Y) und der Hochachse (Z) verfahrbar ausgebildet ist, um die Vielzahl der Feldsensoren gleichzeitig zu verfahren.

7. Vorrichtung (100) nach einem der vorstehenden Ansprüche, wobei das Positioniersystem mehrere Sensorhalterungen (126) aufweist, die jeweils unabhängig voneinander entlang einer Längsachse (X), einer Querachse (Y) und einer Hochachse (Z) verfahrbar ausgebildet sind, und wobei an jeder Sensorhalterung eine Vielzahl von Feldsensoren (118) befestigt sind, um mehrere Prüfstellen (112) des Batteriemoduls (104) zu prüfen.

8. Vorrichtung (100) nach einem der vorstehenden Ansprüche, wobei die Auswertungseinrichtung eine Vergleichsdatenbank aufweist, in der Vergleichsdaten hinterlegt sind, und die Auswertungseinrichtung ist dazu eingerichtet, die erfassten Flussdichten und/oder Feldstärken mit den Vergleichsdaten zu vergleichen, um auf die Kontaktierungsqualität zu schließen.

9. Verfahren zum Prüfen einer Zellkontaktierung von Batteriezellen (102) eines Batteriemoduls (104), umfassend die Schritte:
- Bereitstellen (S1) eines Batteriemoduls (104), wobei das Batteriemodul (104) mehrere elektrisch parallel über ein Kontaktierungssystem (106) verbundene Batteriezellen (102) aufweist;
- Positionieren (S2) einer Sensoreinrichtung (110) an wenigstens einer Prüfstelle (112) des Batteriemoduls (104) mit einem Sensorpositioniersystem (108);
- Erzeugen (S3) eines Batteriezellenstroms (I) zwischen Kontaktstellen (115, 116) der Batteriezellen (102) durch Entladen der Batteriezellen (102) oder Laden der Batteriezellen (102);
- Erfassen (S4) eines Feldes (B) im Bereich der wenigstens einen Prüfstelle (112), das durch den erzeugten Batteriezellenstrom (I) erzeugt wird; und
- Auswerten (S5) des erfassten Feldes (B) zur Bestimmung einer Kontaktierungsqualität der Zellkontaktierung an der wenigstens einen Prüfstelle (112), wobei
das Verfahren mittels einer Vorrichtung (100) zum Prüfen einer Zellkontaktierung von Batteriezellen (102) eines Batteriemoduls (104) nach einem der vorstehenden Ansprüche 1 bis 8 ausgeführt wird.

## Claims

1. An apparatus (100) for testing a cell contact of battery cells (102) of a battery module (104), wherein a plurality of battery cells (102) of the battery module (104) are electrically connected in parallel via a contacting system (106, 107), the apparatus comprising:
- a sensor positioning system (108) for positioning a sensor device (110) at a plurality of test points (112) of the battery module (104), wherein the sensor positioning system is configured to be displaceable along a longitudinal axis (X), a transverse axis (Y) and a vertical axis (Z) for positioning the sensor device; and
- a current generation circuit (114) for generating a battery cell current, wherein the battery cell current (I) is a discharge current from the battery cell (102) or a charging current into the battery cell (102), wherein
- the sensor device (110) is configured with at least one field sensor (118),
wherein after positioning the sensor device at one of the test points (112) the field sensor (118) is designed to detect a field which is in the region of the test point (112) and which is generated by the battery cell current (I) generated by the current generation circuit (114), the field sensor (118) having at least two sensors (124, 125), and wherein the apparatus also has
- an evaluation device for evaluating the field detected in the region of the test point,
**characterised in that** the evaluation device is designed to determine a contact quality of the cell contact at the test point or at a plurality of test points by evaluating the detected flux density and/or the detected field strength,
wherein one of the sensors (124) is configured to detect a field generated in the region of an anode contact point (115) of the battery cell (102) and another of the sensors (125) is configured to detect a field generated in the region of a cathode contact point (116), in particular in order to test simultaneously the field at the anode contact point and the cathode contact point of the battery cell.

2. The apparatus (100) according to Claim 1, wherein
- the sensor device (110) is designed to detect with the field sensor (118) a magnetic flux density (B) and/or a magnetic field strength (H), and wherein the apparatus (100) is designed to evaluate with an evaluation device (120) the detected magnetic flux density (B) and/or the magnetic field strength (H) of the detected field; and/or
- the sensor device (110) is designed to detect with the field sensor (118) an electrical flux density (D) and/or an electrical field strength (E), wherein the apparatus (100) is designed to evaluate with an evaluation device (120) the detected electrical flux density (D) and/or the electrical field strength (E) of the detected field.

3. The apparatus (100) according to Claim 1 or 2, wherein the battery cells (102) are electrically pre-charged and the current generation circuit (114) is configured as a discharge circuit with a load resistor (122) to discharge the pre-charged battery cells via the contacting system (106) in order to generate the battery cell current as discharge current between contact points (115, 116) of the battery cells (102).

4. The apparatus (100) according to one of the preceding claims, wherein the battery cells (102) are electrically chargeable and the current generation circuit (114) is configured as a charging circuit for charging the battery cells (102) via the contacting system (106) in order to generate the battery cell current as a charging current between contact points (115, 116) of the battery cells (102).

5. The apparatus (100) according to one of the preceding claims, wherein the field sensor (118) is configured with a Hall sensor and/or with an electrical coil.

6. The apparatus (100) according to one of the preceding claims, wherein the sensor device (110) has a plurality of field sensors (118) in order to test simultaneously a plurality of test points (112) of the battery module (104) in each case with a field sensor (118), wherein the plurality of field sensors (118) are fastened to a sensor holder (126) of the positioning system (108) and the sensor holder (126) is configured to be displaceable along the longitudinal axis (X), the transverse axis (Y) and the vertical axis (Z) in order to displace the plurality of field sensors simultaneously.

7. The apparatus (100) according to one of the preceding claims, wherein the positioning system has a plurality of sensor holders (126) which are configured in each case to be displaceable independently of one another along a longitudinal axis (X), a transverse axis (Y) and a vertical axis (Z), and wherein a plurality of field sensors (118) are fastened to each sensor holder in order to test a plurality of test points (112) of the battery module (104).

8. The apparatus (100) according to one of the preceding claims, wherein the evaluation device has a comparison database in which comparison data are stored, and the evaluation device is designed to compare the detected flux densities and/or field strengths with the comparison data in order to draw conclusions about the contact quality.

9. A method for testing a cell contact of battery cells (102) of a battery module (104), comprising the steps:
- providing (S1) a battery module (104), wherein the battery module (104) has a plurality of battery cells (102) electrically connected in parallel via a contacting system (106);
- positioning (S2) a sensor device (110) at at least one test point (112) of the battery module (104) with a sensor positioning system (108);
- generating (S3) a battery cell current (I) between contact points (115, 116) of the battery cells (102) by discharging the battery cells (102) or charging the battery cells (102);
- detecting (S4) a field (B) in the region of the at least one test point (112) which is generated by the generated battery cell current (I); and
- evaluating (S5) the detected field (B) for determining a contact quality of the cell contact at the at least one test point (112), wherein
the method is carried out by means of an apparatus (100) for testing a cell contact of battery cells (102) of a battery module (104) according to one of the preceding Claims 1 to 8.

## Revendications

1. Dispositif (100) de contrôle du contactage des cellules de batterie (102) d'un module de batterie (104), plusieurs cellules de batterie (102) du module de batterie (104) étant électriquement reliées en parallèle par un système de contactage (106, 107), le dispositif comprenant :
- un système de positionnement (108) d'un dispositif de capteurs (110) pour le positionnement par rapport à une pluralité de points de contrôle (112) du module de batterie (104), le système de positionnement de capteurs étant conçu pour pouvoir être déplacé le long d'un axe longitudinal (X), d'un axe transversal (Y) et d'un axe normal (Z) pour positionner le dispositif de capteurs (110); et
- un circuit de génération de courant (114) pour la production d'un courant de cellule de batterie, le courant de cellule de batterie (I) étant un courant de décharge provenant de la cellule de batterie (102) ou un courant de charge vers la cellule de batterie (102),
- le dispositif de capteurs (110) étant doté d'au moins un capteur de champ (118), le capteur de champ (118) étant configuré pour détecter après le positionnement du dispositif de capteurs à l'un des points de contrôle (112) un champ produit au niveau du point de contrôle (112) par le courant de cellules de batterie (I) produit par le circuit de génération de courant (114), le capteur de champ (118) présentant au moins deux capteurs (124,125) et le dispositif présentant en outre
- un dispositif d'évaluation du champ détecté au niveau du point de contrôle, **caractérisé en ce que** le dispositif d'évaluation étant configuré pour déterminer une qualité du contactage de ou des cellules au point de contrôle ou à plusieurs points de contrôle par évaluation de la densité de flux et/ou de l'intensité de champ détectées, l'un des capteurs (124) étant conçu pour détecter un champ produit au niveau d'un contact d'anode (115) de la cellule de batterie (102) et un autre des capteurs (125) étant conçu pour détecter un champ produit au niveau d'un contact de cathode (116), notamment pour contrôler simultanément le champ au niveau du contact d'anode et du contact de cathode de la cellule de batterie.

2. Dispositif (100) selon la revendication 1,
- le dispositif de capteurs (110) avec le capteur de champ (118) étant configuré pour détecter une densité de flux magnétique (B) et/ou une intensité de champ magnétique (H) et le dispositif (100) avec un dispositif d'évaluation (120) étant configuré pour évaluer la densité de flux magnétique (B) et/ou l'intensité de champ magnétique (H) du champ détecté, et/ou
- le dispositif de capteurs (110) avec le capteur de champ (118) étant configuré pour détecter une densité de flux électrique (D) et/ou une intensité de champ électrique (E), le dispositif (100) avec un dispositif d'évaluation (120) étant configuré pour évaluer la densité de flux électrique (D) et/ou l'intensité de champ électrique (E) du champ détecté.

3. Dispositif (100) selon la revendication 1 ou 2, les cellules de batterie (102) étant électriquement préchargées et le circuit de génération de courant (114) étant conçu comme circuit de décharge avec une résistance de charge (122) pour décharger par le système de contactage (106) les cellules de batterie préchargées et produire le courant de cellules de batterie comme courant de décharge entre les points de contact (115, 116) des cellules de batterie (102).

4. Dispositif (100) selon l'une des revendications précédentes, les cellules de batterie (102) pouvant être électriquement chargées et le circuit de génération de courant (114) étant conçu comme circuit de charge pour charger par le système de contactage (106) les cellules de batterie (102) et produire le courant de cellules de batterie comme courant de charge entre les points de contact (115, 116) des cellules de batterie (102).

5. Dispositif (100) selon l'une des revendications précédentes, le capteur de champ (118) étant réalisé avec un capteur de Hall et/ou une bobine électrique.

6. Dispositif (100) selon l'une des revendications précédentes, le dispositif de capteurs (110) présentant une pluralité de capteurs de champ (118) pour contrôler simultanément plusieurs points de contrôle (112) du module de batterie (104) avec respectivement un capteur de champ (118), la pluralité de capteurs de champ (118) étant fixée à un support de capteurs (126) du système de positionnement (108) et le support de capteurs (126) étant conçu pour pouvoir être déplacé le long d'un axe longitudinal (X), d'un axe transversal (Y) et d'un axe normal (Z) pour déplacer simultanément l'ensemble des capteurs de champ.

7. Dispositif (100) selon l'une des revendications précédentes, le système de positionnement présentant plusieurs supports de capteurs (126) lesquels sont conçus pour pouvoir être respectivement déplacés indépendamment les uns des autres le long d'un axe longitudinal (X), d'un axe transversal (Y) et d'un axe normal (Z) et une pluralité de capteurs de champ (118) étant fixée à chaque support de capteurs pour contrôler plusieurs points de contrôle (112) du module de batterie (104).

8. Dispositif (100) selon l'une des revendications précédentes, le dispositif d'évaluation présentant une base de données de référence contenant des données comparatives, le dispositif d'évaluation étant conçu pour comparer les densités de flux et/ou les intensités de champ avec les données comparatives pour en tirer des conclusions quant à la qualité du contactage.

9. Procédé de contrôle d'un contactage de cellules de batterie (102) d'un module de batterie (104) comprenant les étapes suivantes :
- mise à disposition (S1) d'un module de batterie (104), le module de batterie (104) présentant plusieurs cellules de batterie (102) électriquement connectées en parallèle par un système de contactage (106);
- positionnement (S2) à au moins un point de contrôle (112) du module de batterie (104) d'un dispositif de capteurs (110) au moyen d'un système (108) de positionnement de capteurs ;
- . production (S3) d'un courant de cellules de batterie (I) entre les points de contact (115, 116) des cellules de batterie (102) par déchargement des cellules de batterie (102) ou chargement des cellules de batterie (102);
- détection (S4) au niveau du ou des points de contrôle (112) d'un champ (B) produit par le courant de cellules de batterie (I) produit ;
- évaluation (S5) du champ (B) détecté pour déterminer une qualité de contact du contactage des cellules au(x) point(s) de contrôle (112),
le procédé étant effectué au moyen d'un dispositif (100) de contrôle du contactage des cellules de batterie (102) d'un module de batterie (104) selon l'une des revendications précédentes 1 à 8.
